# EUROPÄISCHE PATENTSCHRIFT

(11) **EP 2 433 474 B1**
(45) Veröffentlichungstag und Bekanntmachung des Hinweises auf die Patenterteilung: **12.02.2014**
(21) Anmeldenummer: 10724280.2
(22) Anmeldetag: 19.05.2010
(51) Int. Cl.: H05K 1/02, F21V 29/00

(54) **LEUCHTDIODE MIT KÜHLKÖRPER**
LIGHT DIODE WITH COOLING BODY
DIODE LUMINESCENTE DOTÉE D'UN DISSIPATEUR THERMIQUE

(30) Priorität: 20.05.2009 DE 102009022255
(43) Veröffentlichungstag der Anmeldung: 28.03.2012
(73) Patentinhaber: Eutegra AG, 60325 Frankfurt am Main (DE)
(72) Erfinder: GRAUVOGEL, Ulrich, 90451 Nürnberg (DE)
(74) Vertreter: Jaeschke, Rainer
(86) Internationale Anmeldenummer: PCT/EP2010/003095
(87) Internationale Veröffentlichungsnummer: WO 2010/133365

(56) Entgegenhaltungen:
- EP-A1- 1 139 019
- WO-A1-2006/104325
- WO-A1-2006/105644
- GB-A- 2 163 598
- US-A1- 2006 001 361
- US-B1- 6 490 161

## Beschreibung

Die Erfindung betrifft eine Anordnung einer Leuchtdiode auf einer Leiterplatte, welche Leuchtdiode Anschlusskontakte und einen Leuchtkörper aufweist, der mit einem der Leuchtdiode zugeordneten separaten Kühlkörper verbunden ist, wobei die Leiterplatte eine Durchbrechung aufweist, durch welche die Leuchtdiode mit dem Kühlkörper führbar ist derart, dass die Anschlusskontakte mit Leiterbahnen in Kontakt kommen, die auf der dem Kühlkörper abgewandten Seite der Leiterplatte angeordnet sind.

Leuchtdioden gewinnen immer mehr Bedeutung für die Erzeugung von Licht. Bei einer hohen Lichtausbeute produzieren bekannte Leuchtdioden im Leuchtkörper eine große Wärmemenge, die abgeführt werden muss. Dies bereitet bei den üblichen Leuchtdiodenbauarten Probleme, da diese wie elektronische Bauelemente auf Leiterplatten aufgelötet werden. Die Wärme kann demnach nur durch Konvektionskühlung der Leuchtkörper der Leuchtdioden erfolgen.

Weiterhin ist es bekannt, dass für hohe Lichtleistungen mehrere Leuchtdioden in einem Leuchtdiodenfeld auf einer Leiterplatte angeordnet werden. Die Leuchtdioden werden auf der Leiterplatte mit den Leiterbahnen verlötet. Hier besteht ein Problem darin, dass bei Ausfall einer einzelnen Leuchtdiode das gesamte Leuchtdiodenfeld unbrauchbar wird. Ein Austausch nur einer Leuchtdiode ist bei derartigen Leuchtdiodenfeldern mit erhöhtem Aufwand verbunden. Es muss die defekte Leuchtdiode entfernt und eine neue aufgelötet werden. Dies kann nur manuell erfolgen, und es besteht die Gefahr, dass durch den Lötvorgang benachbarte Leuchtdioden beschädigt oder zerstört werden.

Aus der US 7,138,667 B2 ist eine Anordnung einer Leuchtdiode auf einer Leiterplatte bekannt, bei welcher die Leuchtdiode mit einer Klemme auf einer Leiterplatte gehalten wird. Die Klemme weist hierzu Haltezungen auf, die durch entsprechende Öffnungen der Leiterplatte geführt werden. Ein Fortsatz der Leuchtdiode ragt dabei durch die Leiterplatte hindurch. Die US 2008/0143245 A1 beschreibt eine andere Anordnung einer Leuchtdiode. Der Leuchtkörper der Leuchtdiode wird hier durch eine Durchbrechung eines Substrats geführt und von der Einführseite an dem Substrat gehalten. Die US 2006/0001361 A1 beschreibt eine Anordnung gemäß der Einleitung des Anspruchs 1.

Der Erfindung liegt die Aufgabe zugrunde, eine Anordnung einer Leuchtdiode auf einer Leiterplatte so auszubilden, dass die Leuchtdiode gut auf der Leiterplatte montierbar ist.

Die Aufgabe wird gemäß der Erfindung dadurch gelöst, dass die Leuchtdiode mittels eines Klemmmechanismus auf der Leiterplatte gehalten ist, der eine Halterung, die von der dem Leuchtkörper abgekehrten Seite der Leiterplatte durch die Durchbrechung hindurchgeführt ist, und eine Halteklemme aufweist, die mit der Halterung zusammenwirkt und die Leuchtdiode zwischen sich und der Halterung einklemmt und somit auf der Leiterplatte hält und die Anschlusskontakte auf die Leiterbahnen der Leiterplatte drückt. Es ist hierbei nur noch erforderlich, dass die Anschlusskontakte auf die Leiterbahnen gedrückt werden, um zum einen die Leuchtdiode auf der Leiterplatte zu halten und zum anderen, um die Leuchtdiode elektrisch mit den Leiterbahnen zu verbinden. Weitere Maßnahmen sind nicht erforderlich, so dass die Montage vereinfacht wird.

Auch ist es möglich, dass die Leiterbahnen auf der dem Kühlkörper zugewandten Seite der Leiterplatte angeordnet sind. Dann wird die Leuchtdiode mit dem Leuchtkörper zuerst durch die Durchbrechung geführt, bis die Anschlusskontakte an die Leiterbahnen stoßen. In dieser Position wird die Leuchtdiode dann gehalten.

Es kann vorgesehen werden, dass die Grundfläche des Leuchtkörpers größer ist als die zugewandte Fläche des Kühlkörpers, so dass sich der Leuchtkörper in der montierten Lage auf der Leiterplatte abstützt. Hierdurch wird ein besonders sicherer Halt der Leuchtdiode auf der Leiterplatte bewirkt. Es kann aber auch vorgesehen werden, dass der Leuchtkörper Rastelemente aufweist, mit denen er auf der Leiterplatte gehalten wird.

Im Einzelnen kann die Anordnung so getroffen sein, dass die Halterung von der einen Seite durch eine entsprechende Durchbrechung in der Leiterplatte geführt wird. Die Halterung selbst weist ebenfalls eine Durchbrechung auf, durch die der Kühlkörper der Leuchtdiode von der anderen Seite eingeführt werden kann. Weiterhin umfasst die Halterung Rastmittel, die mit korrespondierenden Rastelementen der Halteklemme zusammenwirken, die von der anderen Seite über die Halterung montiert wird. Die Halteklemme schließt damit die Leuchtdiode zwischen sich und der Halterung ein und hält diese klemmend auf der Leiterplatte.

Zweckmäßig ist es, wenn die Halteklemme die Anschlusskontakte auf die Leiterbahnen der Leiterplatte drückt. Hierdurch wird die Montage erleichtert, da die Leuchtdiode durch die Halterung auf der Leiterplatte ausgerichtet ist. Durch die Halteklemme erfolgt die Fixierung der Leuchtdiode in der montierten Gebrauchslage, und der elektrische Kontakt wird hergestellt.

Günstig ist es, wenn zwischen der Halteklemme und den Anschlusskontakten eine Schicht aus flexiblem oder elastischem Material vorhanden ist, durch die die Anschlusskontakte elastisch auf die Leiterbahn gedrückt werden. Dieses flexible Material kann ein Elastomer oder Silikon sein. Hierdurch wird erreicht, dass die Anschlusskontakte sicher in elektrischer Verbindung mit den Leiterbahnen gebracht werden.

Es kann weiterhin vorgesehen sein, dass die Halteklemme lösbar mit der Halterung verbunden ist. Dies hat den Vorteil, dass eine defekte Leuchtdiode mit einfachen Mitteln austauschbar ist. Es ist lediglich erforderlich, die Halteklemme zu lösen und die Leuchtdiode auszutauschen. Anschließend wird die Halteklemme wieder mit der Halterung verbunden.

Gemäß einer weitergehenden Ausführungsform der Erfindung ist vorgesehen, dass die Halteklemme optische Mittel aufweist. Die optischen Mittel können beweglich auf der Halteklemme angeordnet sein. Hierbei ist vorgesehen, dass die optischen Mittel mittels elektromechanischer Mittel, insbesondere mittele Piezoelementen, verstellbar sind. Hierdurch wird erreicht, dass jeder Leuchtdiode ein separates optisches Mittel, beispielsweise eine Linse oder Blende, zugeordnet ist. Jede Leuchtdiode kann demnach individuell beeinflusst werden.

Weiterhin kann vorgesehen werden, dass die elektromechanischen Mittel über die Leiterplatte ansteuerbar sind. Es ist demnach lediglich erforderlich, dass die Leiterplatte im Bereich der Leuchtdiode zusätzliche Leiterbahnen aufweist, die zum Ansteuern der elektromechanischen Mittel zum Beeinflussen der optischen Mittel erforderlich sind. Die elektrischen Kontakte können ebenfalls beim Verbinden der Halteklemme mit der Halterung hergestellt werden.

Weiterhin kann vorgesehen werden, dass mehrere Leuchtdioden auf einer Leiterplatte angeordnet sind. Hier wird der Vorteil der Erfindung besonders deutlich, da es nunmehr möglich ist, einzelne defekte Leuchtdioden aus einem Leuchtdiodenfeld zu entfernen und durch neue zu ersetzen. Es sind keine Lötarbeiten mehr erforderlich, durch die die elektronische Schaltung auf der Leiterplatte eventuell Schaden nehmen könnte. Der Ausschuss wird somit deutlich reduziert.

Der Leuchtkörper ist mit einem der Leuchtdiode zugeordneten separaten Kühlkörper verbunden. Dies hat den Vorteil, dass die durch den Betrieb der Leuchtdiode erzeugte Wärme unmittelbar vom Leuchtkörper durch den Kühlkörper abgeführt werden kann.

In der Regel wird die Anordnung so getroffen sein, dass die Leuchtdiode auf einer Leiterplatte montiert ist. Hier ist vorgesehen, dass sich der Kühlkörper von der Lichtaustrittsseite gegenüberliegenden Seite von der Leuchtdiode weg erstreckt, so dass sich, von oben auf die Lichtaustrittsseite gesehen, der Kühlkörper in der montierten Lage unterhalb, das heißt vom Leuchtkörper abgekehrten Seite der Leiterplatte befindet. Dann braucht nur noch die Unterseite der Leiterplatte mit Kühlluft beaufschlagt zu werden, um die Abwärme abführen zu können.

Es ist günstig, wenn zwischen den Kühlkörper und den Leuchtkörper wenigstens eine Schicht aus einem wärmeleitenden Material, beispielsweise aus einem Kupfer- oder Nickelwerkstoff, angeordnet ist. Hierdurch wird die Wärmeableitung von dem Leuchtkörper in den Kühlkörper insbesondere in dessen Breitenerstreckung wesentlich verbessert. Auch wird dadurch erreicht, dass von dem Leuchtkörper zum Kühlkörper ein metallischer Durchgang besteht. Der Kühlkörper kann dann mit dem Leuchtkörper ohne weiteres verschweißt werden. Der Kühlkörper kann aus einem Aluminiumwerkstoff bestehen. Ein derartiger Werkstoff ist leicht im Gewicht und problemlos zu bearbeiten.

Gemäß einer bevorzugten Ausführungsform der Erfindung ist vorgesehen, dass der Kühlkörper Kühlrippen aufweist, die sich von dem Leuchtkörper weg erstrecken. Hierdurch wird eine relativ große Wärmeübertragungsfläche gebildet, die zudem nicht im Lichtausfallsbereich der Leuchtdiode liegt. Eine Beeinträchtigung der optischen Eigenschaften der Leuchtdiode ist damit nicht zu befürchten.

Günstig kann es sein, wenn die dem Leuchtkörper zugewandte Oberfläche des Kühlkörpers kleiner oder gleich groß ist wie die Unterseite des Leuchtkörpers. Dadurch wird erreicht, dass der Kühlkörper, von oben gesehen, die Kontur der Leuchtdiode nicht verändert. Die Leuchtdiode kann demnach auch auf kleinstem Raum angeordnet werden.

Zweckmäßig ist es, wenn die Anschlussdrähte seitlich vom Leuchtkörper angeordnet sind. Bei bekannten Leuchtdioden befinden sich die Anschlussdrähte in der Regel unterhalb des Leuchtkörpers. Dort befindet sich jedoch der Kühlkörper für die betreffende Leuchtdiode. Die Anschlussdrähte können sich daher seitlich vom Leuchtkörper weg erstrecken, so dass die elektrische Verbindung mit einfachen Mitteln herstellbar ist.

Die Anschlussdrähte können als nachgiebige oder federnde Anschlusskontakte ausgebildet sein, die mit Leiterbahnen auf einer Leiterplatte in Verbindung bringbar sind. Dies hat den Vorteil, dass die Leuchtdiode federnd auf der Leiterbahn montiert werden kann. Die federnden Anschlusskontakte ermöglichen einen guten elektrischen Kontakt, so dass die Stromzufuhr ohne weiteres möglich ist. Ein Verlöten mit den Leiterbahnen ist nicht mehr notwendig.

Bei der Anordnung, bei welcher die Leuchtdiode von der dem Kühlkörper zugewandten Seite der Leiterplatte durch diese geführt wird, kann die Halterung auf dieser Seite an der Leiterplatte vorhanden sein. Die Halterung kann mit der Leiterplatte beispielsweise verklebt, verrastet oder verschraubt sein. Die Leuchtdiode wird dann von dieser Seite durch eine Durchbrechung der Halterung geführt, bis die Kontakte an die Leiterbahnen anstoßen. Dann wird die Leuchtdiode mit der Halteklemme klemmend an der Halterung und somit an der Leiterplatte gehalten. Dadurch wird auch der elektrische Kontakt hergestellt. Bei dieser Anordnung ist von der dem Kühlkörper abgewandten Seite der Leiterplatte lediglich der Leuchtkörper der Leuchtdiode sichtbar. Diese Art der Montage ist dann günstig, wenn der Kühlkörper im Vergleich zur Leuchtdiode oder deren Leuchtkörper einen größeren Querschnitt aufweist, so dass anderenfalls ein Durchführen des Kühlkörpers nur bei größeren Durchbrechungen der Leiterplatte möglich wäre.

Eine Leuchtdiode der oben erläuterten Art hat den Vorteil, dass die Wärme gut und ohne weitere Hilfsmittel abgeführt werden kann. Das Vorsehen von seitlichen, federnden Anschlusskontakten erlaubt eine einfache Montage der Leuchtdiode auf einer Leiterplatte. Es ist nicht mehr erforderlich, dass die Leuchtdiode separat auf der Leiterplatte aufgelötet werden muss. Vielmehr reicht ein mechanisches Andrücken der federnden Anschlusskontakte auf die Leiterbahnen aus, um einen guten und sicheren elektrischen Kontakt zu gewährleisten. Hierdurch wird zudem möglich, dass eine defekte Leuchtdiode ausgewechselt werden kann, ohne dass die gesamte Schaltung, die auf der Leiterplatte vorhanden ist, ausgewechselt werden muss. Auch werden aufwändige Lötarbeiten bei einem Austausch der Leuchtdioden vermieden. Schließlich kann die Funktion der Leuchtdiode beim Montagevorgang geprüft werden, bevor die Verbindung mit der Leiterplatte erfolgt. Ein abschließendes Verrasten erfolgt erst bei bestandener Funktionsprüfung. Bis dahin kann eine defekte Leuchtdiode schnell und problemlos ersetzt werden.

Weiterhin kann vorgesehen werden, dass mehrere Leuchtdioden auf einer Leiterplatte angeordnet sind. Hier wird der Vorteil der Erfindung besonders deutlich, da es nunmehr möglich ist, einzelne defekte Leuchtdioden aus einem Leuchtdiodenfeld zu entfernen und durch neue zu ersetzen. Es sind keine Lötarbeiten mehr erforderlich, durch die die elektronische Schaltung auf der Leiterplatte eventuell Schaden nehmen könnte. Der Ausschuss wird somit deutlich reduziert.

Vorstehend wurde die Erfindung anhand eines Beispiels erläutert, bei welchem die Leuchtdioden über einer Halterung und eine Halteklemme mit der Leiterbahn verbunden sind. Es ist natürlich auch möglich, dass die Leiterplatte entsprechende Aussparungen aufweist, in die die Rastelemente der Halteklemme eingreifen. Auf eine separate Halterung kann daher auch verzichtet werden.

Die Leuchtdiode kann auch auf einem flexiblen Leiterplattenelement fixiert sein, bevor sie auf die Leiterplatte montiert wird. Die Leuchtdioden bauen relativ klein, so dass für die Handhabung ein Leiterplattenelement, auf dem die Leuchtdiode angeordnet ist, günstig ist. Das flexible Leiterplattenelement erlaubt zudem die gewünschte elastische Kontaktierung mit der Leiterplatte.

Die Erfindung wird im Folgenden anhand der schematischen Zeichnung näher erläutert. Es zeigen:

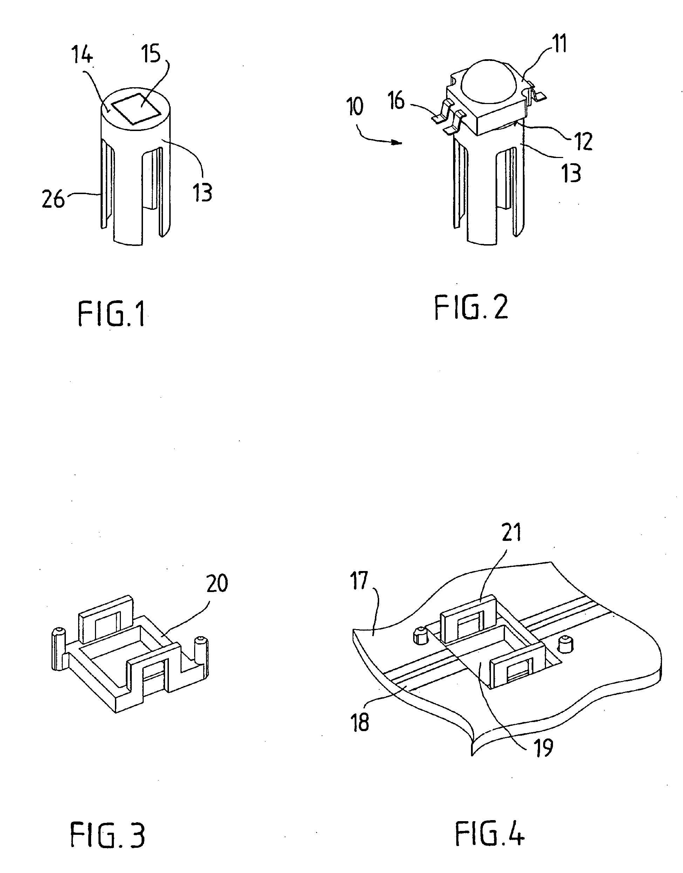

- Figur 1: den Kühlkörper für eine Leuchtdiode gemäß der Erfindung,
- Figur 2: die Leuchtdiode und den Kühlkörper in der zusammengesetzten Lage,
- Figur 3: eine Halterung für die Leuchtdiode auf der Leiterplatte,
- Figur 4: die vorbereitete Leiterplatte zur Aufnahme einer Leuchtdiode,
- Figur 5: die Leuchtdiode gemäß der Erfindung in der vormontierten Lage auf einer Leiterplatte, und
- Figur 6: die Leuchtdiode gemäß der Erfindung in der montierten Lage auf einer Leiterplatte.

Die in der Zeichnung dargestellte Leuchtdiode 10 weist einen Leuchtkörper 11 auf, in dem die elektronischen Mittel einer Leuchtdiode angeordnet sind. Der Leuchtkörper 11 ist mit seiner Unterseite 12 auf einem Kühlkörper 13 angeordnet. Im Einzelnen ist die Anordnung so getroffen, dass der Leuchtkörper 11 im Wesentlichen vollflächig auf der Oberseite 14 des Kühlkörpers 13 aufliegt und mit ihm in wärmeleitender Verbindung steht. Hierzu sind Kleber bekannt, die eine Wärmeübertragung von dem Leuchtkörper 11 auf den Kühlkörper 13 ermöglichen. Es kann vorgesehen sein, dass der Kühlkörper 13 auf seiner dem Leuchtkörper 11 zugewandten Oberfläche 14 eine Schicht oder ein Element 15 aus einem wärmeleitenden Material, beispielsweise aus Aluminium, aufweist. Hierdurch wird die Wärmeabfuhr vom Leuchtkörper in den Kühlkörper weiter unterstützt. Auch kann dann der Leuchtkörper mit dem Kühlkörper verlötet werden.

Der Leuchtkörper 11 weist Anschlusskontakte 16 auf, über die die Leuchtdiode mit elektrischem Strom versorgt wird. Bei dem in der Zeichnung dargestellten Ausführungsbeispiel sind vier Anschlusskontakte vorgesehen, die seitlich aus dem Leuchtkörper hervorstehen. Hierdurch können verschiedene Farben erzeugt werden.

Die in der Zeichnung dargestellte Leuchtdiode 10 kann auf einer Leiterplatte 17 montiert werden. Die Leiterplatte trägt zum einen die Leuchtdiode 10 und dient zum Ansteuern der Leuchtdiode über Leiterbahnen 18, die in elektrischem Kontakt zu den Anschlusskontakten 16 stehen. Im einzelnen ist die Anordnung so getroffen, dass die Leiterplatte 17 an der Stelle, an der die Leuchtdiode platziert werden soll, eine Durchbrechung 19 aufweist, durch die der Kühlkörper 13 der Leuchtdiode 10 passt. Wird die Leuchtdiode von der anderen Seite durch die Leiterplatte geführt, passt die Leuchtdiode oder zumindest der Leuchtkörper durch die Durchbrechung. Es ist eine Halterung 20 vorgesehen, die von unten, der dem Leuchtkörper 11 abgekehrten Seite, der Leiterplatte 17 in der Durchbrechung montierbar ist.

Die Halterung 20 weist sich nach oben durch die Durchbrechung der Leiterplatte 17 hindurch erstreckende Rastelemente 21 auf, die mit Rastelementen 22 einer Halteklemme 23 zusammenwirken. Die Halteklemme 23 wird in der montierten Lage der Leuchtdiode 10 von oben über die Leuchtdiode gesteckt, und die Rastelemente 22 sind mit den Rastelementen 21 der Halterung 20 verbunden. Die Leuchtdiode wird somit klemmend zwischen der Halterung 20 und der Halteklemme 23 gehalten. Es können noch Führungsstifte 24 vorgesehen werden, die an der Halterung 20 befestigt sind und die mit in der Zeichnung nicht gezeigten Führungslöchern in der Halteklemme zusammenwirken. Dadurch wird eine genaue Ausrichtung der Halteklemme über der Halterung ermöglicht.

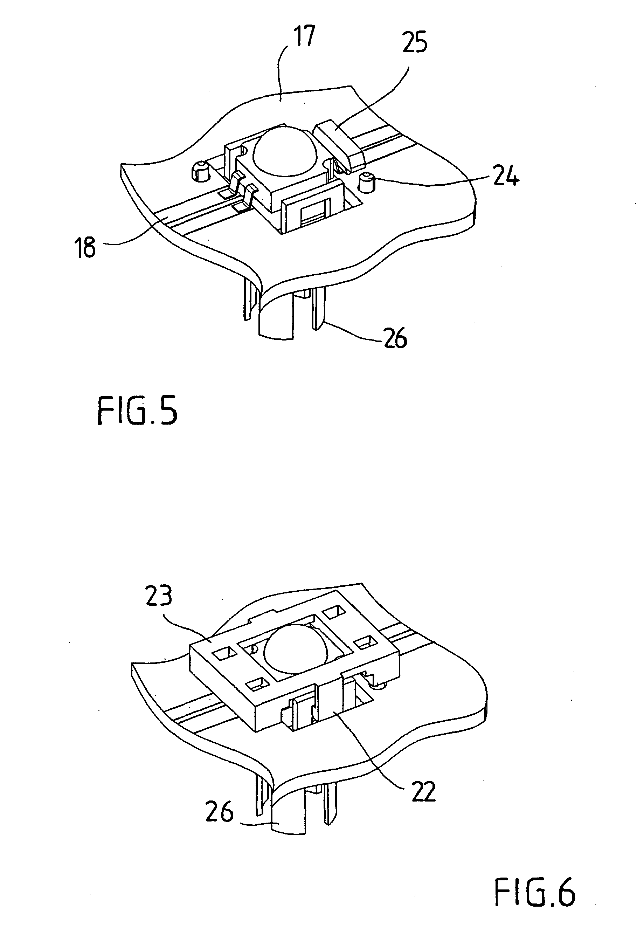

Wie insbesondere in Figur 5 ersichtlich, stützt sich die Leuchtdiode 10 mit den Anschlusskontakten 16 federnd auf den Leiterbahnen 18 ab. Ein sicherer elektrischer Kontakt wird hierdurch gewährleistet. Es kann zudem ein elastisches Druckelement 25 vorgesehen sein, das oberhalb der Anschlusskontakte 16 verläuft und das durch die Halteklemme 23 nach unten auf die Leiterplatte 17 gedrückt wird. Die in etwa parallel zu der Leiterplatte verlaufenden freien Enden der Anschlusskontakte 16 werden dadurch sicher auf die Leiterbahnen 18 gedrückt.

Der Kühlkörper kann aus einem wärmeleitenden Material, insbesondere aus einem Aluminiumwerkstoff, bestehen. Es können Kühlrippen 26 vorgesehen werden, die sich von dem Leuchtkörper 11 weg erstrecken. Die Baueinheit bestehend aus Leuchtkörper 11 und Kühlkörper 13 ist lediglich klemmend mit der Leiterplatte 17 verbunden. Ein Austausch einer defekten Leuchtdiode ist daher problemlos möglich.

Weiterhin ragen die Kühlrippen 26 des Kühlkörpers 13 in der montierten Lage nach unten von der Leiterplatte 17 weg. Es ist lediglich erforderlich, dass dieser Bereich der Leiterplatte mit Kühlluft beaufschlagt wird, um eine ausreichende Kühlung der Leuchtdiode zu gewährleisten.

## Patentansprüche

1. Anordnung einer Leuchtdiode auf einer Leiterplatte (17), welche Leuchtdiode (10) Anschlusskontakte (16) und einen Leuchtkörper (11) aufweist, der mit einem der Leuchtdiode zugeordneten separaten Kühlkörper (13) verbunden ist, wobei die Leiterplatte (17) eine Durchbrechung (19) aufweist, durch welche die Leuchtdiode mit dem Kühlkörper (13) führbar ist derart, dass die Anschlusskontakte (16) mit Leiterbahnen (18) in Kontakt kommen, die auf der dem Kühlkörper (13) abgewandten Seite der Leiterplatte (17) angeordnet sind, **dadurch gekennzeichnet, dass** die Leuchtdiode (10) mittels eines Klemmmechanismus (20, 23) auf der Leiterplatte (17) gehalten ist, der eine Halterung (20), die von der dem Leuchtkörper abgekehrten Seite der Leiterplatte (17) durch die Durchbrechung (19) hindurchgeführt ist, und eine Halteklemme (23) aufweist, die mit der Halterung zusammenwirkt und die Leuchtdiode zwischen sich und der Halterung einklemmt und somit auf der Leiterplatte hält und die Anschlusskontakte auf die Leiterbahnen der Leiterplatte drückt.

2. Anordnung einer Leuchtdiode auf einer Leiterplatte, welche Leuchtdiode Anschlusskontakte und einen Leuchtkörper aufweist, der mit einem der Leuchtdiode zugeordneten separaten Kühlkörper verbunden ist, wobei die Leiterplatte eine Durchbrechung aufweist, durch welche die Leuchtdiode führbar ist derart, dass die Anschlusskontakte mit Leiterbahnen in Kontakt kommen, die auf der dem Leuchtkörper abgekehrten Seite der Leiterplatte angeordnet sind, **dadurch gekennzeichnet, dass** die Leuchtdiode mittels eines Klemmmechanismus auf der Leiterplatte gehalten ist, der eine Halterung, die auf der Leiterplatte im Bereich der Durchbrechung auf der Seite mit den Leiterbahnen gehalten ist, und eine Halteklemme aufweist, die mit der Halterung zusammenwirkt und die Leuchtdiode zwischen sich und der Halterung einklemmt und somit auf der Leiterplatte hält und die Anschlusskontakte auf die Leiterbahnen der Leiterplatte drückt.

3. Anordnung nach Anspruch 1 oder 2, **dadurch gekennzeichnet, dass** zwischen der Halteklemme (23) und der Leiterplatte im Bereich der Anschlusskontakte eine Schicht (25) aus flexiblen oder elastischen Material vorhanden ist, durch die die Anschlusskontakte (16) auf die Leiterbahnen (18) gedrückt werden.

4. Anordnung nach einem der Ansprüche 1 bis 3, **dadurch gekennzeichnet, dass** die Halterung (20) sich durch die Durchbrechung (19) erstreckende Rastelemente (21) aufweist, die mit Rastelementen (22) der Halteklemme verbunden sind.

5. Anordnung nach einem der Ansprüche 1 bis 4, **dadurch gekennzeichnet, dass** die Halteklemme (23) lösbar mit der Halterung (20) verbunden ist.

6. Anordnung nach einem der Ansprüche 1 oder 3 bis 5, **dadurch gekennzeichnet, dass** die Halteklemme optische Mittel aufweist.

7. Anordnung nach Anspruch 6, **dadurch gekennzeichnet, dass** die optischen Mittel beweglich auf der der Halteklemme sind.

8. Anordnung nach einem der Ansprüche 6 oder 7, **dadurch gekennzeichnet, dass** die optischen Mittel mittels elektromechanischer Mittel, insbesondere mittels Piezoelementen, verstellbar sind.

9. Anordnung nach Anspruch 8, **dadurch gekennzeichnet, dass** die elektromechanische Mittel über die Leiterplatte ansteuerbar sind.

10. Anordnung nach einem der Ansprüche 1 bis 9, **dadurch gekennzeichnet, dass** auf einer Leiterplatte mehrere Leuchtdioden angeordnet sind.

## Claims

1. Arrangement of a light diode on a circuit board (17), which light diode (10) comprises connecting contacts (16) and a lighting body (11), which is connected with a separate cooling body (13) assigned to the light diode, wherein the circuit board has an aperture (19) through which the light diode with the cooling body (13) is guidable so that the connecting contacts (16) come in contact with strip conductors (18) which are situated on the side of the circuit board facing away from the cooling body (13), **characterized in that** the light diode (10) is maintained by means of a clamping mechanism (20, 23) on the circuit board (17), which clamping mechanism comprises a holder (20) that is guided from the side of the circuit board (17) facing away from the lighting body through the aperture (19), and a retaining clamp (23), which acts in conjunction with the holder and clamps the light diode between itself and the holder and thus holds it on the circuit board and presses the connecting contacts onto the strip connectors of the circuit board.

2. Arrangement of a light diode on a circuit board, which light diode comprises connecting contacts and a lighting body, which is connected with a separate cooling body assigned to the light diode, wherein the circuit board has an aperture through which the light diode is guidable so that the connecting contacts come in contact with strip connectors, which are situated on the side of the circuit board facing away from the lighting body, **characterized in that** the light diode is maintained by means of a clamping mechanism on the circuit board, which clamping mechanism has a holder that is maintained on the circuit board in the area of the aperture on the side with the strip conductors, and a retaining clamp which acts in conjunction with the holder and clamps the light diode between itself and the holder, and thus holds on the circuit board and presses the connecting contacts onto the strip conductors of the circuit board.

3. Arrangement according to claim 1 or 2, **characterized in that** between the retaining clamp (23) and the circuit board in the area of the connecting contacts, a layer (25) of flexible or elastic material is present, through which the connecting contacts (16) are pressed onto the strip conductors (18).

4. Arrangement according to one of claims 1 to 3, **characterized in that** the holder (20) has locking elements (21) extending through the aperture (19), which are connected with locking elements (22) of the retaining clamp.

5. Arrangement according to one of claims 1 to 4, **characterized in that** the retaining clamp (23) is detachably connected with the holder (20).

6. Arrangement according to one of claims 1 or 3 to 5, **characterized in that** the retaining clamp has optical means.

7. Arrangement according to claim 6, **characterized in that** the optical means are movable on the retaining clamp.

8. Arrangement according to one of claims 6 or 7, **characterized in that** the optical means are adjustable by means of electromechanical means, especially by means of piezoelements.

9. Arrangement according to claim 8, **characterized in that** the electromechanical means are controllable via the circuit board.

10. Arrangement according to one of claims 1 to 9, **characterized in that** multiple light diodes are arranged on a circuit board.

## Revendications

1. Arrangement d'une diode électroluminescente sur une plaquette de circuit imprimé (17), cette diode électroluminescente (10) comportant des contacts de connexion (16) et un corps lumineux (11) qui est relié à un dissipateur de chaleur séparé (13) associé à la diode électroluminescente, la plaquette de circuit imprimé (17) comportant un perçage (19) au travers duquel la diode électroluminescente peut être introduite avec le dissipateur de chaleur (13) de sorte que les contacts de connexion (16) viennent en contact avec des lignes conductrices (18) situées sur la face de la plaquette de circuit imprimé (17) située à l'opposé du dissipateur de chaleur (13),
**caractérisé en ce que**
la diode électroluminescente (10) est maintenue sur la plaquette de circuit imprimé (17) au moyen d'un mécanisme de serrage (20, 23) qui comporte un élément de fixation (20) qui est introduit dans le perçage (19) à partir de la face de la plaquette de circuit imprimé (17) située à l'opposé du corps lumineux, ainsi qu'une pince de retenue (23), qui coopère avec l'élément de fixation et bloque la diode électroluminescente entre celle-ci et l'élément de fixation, la maintient ainsi sur la plaquette de circuit imprimé et comprime les contacts de connexion sur les lignes conductrices de la plaquette de circuit imprimé.

2. Arrangement d'une diode électroluminescente sur une plaquette de circuit imprimé, cette diode électroluminescente comportant des contacts de connexion et un corps lumineux qui est relié à un dissipateur de chaleur séparé associé à la diode électroluminescente, la plaquette de circuit imprimé comportant un perçage au travers duquel la diode électroluminescente peut être introduite de sorte que les contacts de connexion viennent en contact avec des lignes conductrices situées sur la face de la plaquette de circuit imprimé située à l'opposé du corps lumineux,
**caractérisé en ce que**
la diode électroluminescente est maintenue sur la plaquette de circuit imprimé au moyen d'un mécanisme de serrage qui comporte un élément de fixation qui est maintenu sur la plaquette de circuit imprimé dans la zone du perçage, sur sa face équipée des lignes conductrices ainsi qu'une pince de retenue qui coopère avec l'élément de fixation et bloque la diode électroluminescente entre celle-ci et l'élément de fixation, la maintient ainsi sur la plaquette de circuit imprimé et comprime les contacts de connexion sur les lignes conductrices de la plaquette de circuit imprimé.

3. Arrangement conforme à la revendication 1 ou 2,
**caractérisé en ce qu'**
entre la pince de retenue (23) et la plaquette de circuit imprimé, dans la zone des contacts de connexion, il est prévu une couche (25) d'un matériau flexible ou élastique par laquelle les contacts de connexion (16) sont comprimés sur les lignes conductrices (18).

4. Arrangement conforme à l'une des revendications 1 à 3,
**caractérisé en ce que**
l'élément de fixation (20) comporte des éléments d'encliquetage (21) s'étendant au travers du perçage (19) qui sont reliés à des éléments d'encliquetage (22) de la pince de retenue.

5. Arrangement conforme à l'une des revendications 1 à 4,
**caractérisé en ce que**
la pince de retenue (23) est reliée de façon amovible à l'élément de fixation (20).

6. Arrangement conforme à l'une des revendications 1 ou 3 à 5,
**caractérisé en ce que**
la pince de retenue comporte des organes optiques.

7. Arrangement conforme à la revendication 6,
**caractérisé en ce que**
les moyens optiques sont mobiles sur la pince de retenue.

8. Arrangement conforme à l'une des revendications 6 ou 7,
**caractérisé en ce que**
les moyens optiques peuvent être réglés par des moyens électromécaniques, en particulier des éléments piézoélectriques.

9. Arrangement conforme à la revendication 8,
**caractérisé en ce que**
les moyens électromécaniques peuvent être commandés par la plaquette de circuit imprimé.

10. Arrangement conforme à l'une des revendications 1 à 9,
**caractérisé en ce que**
plusieurs diodes électroluminescentes sont montées sur une plaquette de circuit imprimé.
